**Europäisches Patentamt**

**European Patent Office**

**Office européen des brevets**

(19)

(11) Veröffentlichungsnummer: **0 145 915 B1**

(12) **EUROPÄISCHE PATENTSCHRIFT**

(45) Veröffentlichungstag der Patentschrift:
**20.04.88**

(21) Anmeldenummer: **84113175.8**

(22) Anmeldetag: **02.11.84**

(51) Int. Cl.⁴: **A 61 B 5/05**, **G 01 N 24/04**, **G 01 N 24/08**, **H 01 P 7/06**

(54) **Messkopf zur Aufnahme hochaufgelöster Kernresonanzsignale.**

(30) Priorität: **19.11.83 DE 3341802**
**02.12.83 DE 3343625**

(43) Veröffentlichungstag der Anmeldung:
**26.06.85 Patentblatt 85/26**

(45) Bekanntmachung des Hinweises auf die Patenterteilung:
**20.04.88 Patentblatt 88/16**

(84) Benannte Vertragsstaaten:
**CH FR GB IT LI**

(56) Entgegenhaltungen:
**DE - B - 1 166 297**
**FR - A - 1 430 222**
**US - A - 3 235 805**

**QST, Juni 1976, James Fisk "Helical-Resonator Design Techniques" Seiten 11-14**

(73) Patentinhaber: **Bruker Medizintechnik GmbH, Silberstreifen, D-7512 Rheinstetten-Forchheim (DE)**

(72) Erfinder: **Zeiger, Heinz, Lerchenstrasse 6, D-7500 Karlsruhe 1 (DE)**

(74) Vertreter: **Patentanwälte Kohler - Schwindling - Späth, Hohentwielstrasse 41, D-7000 Stuttgart 1 (DE)**

## Beschreibung

Die Erfindung geht aus von einem Messkopf für hochauflösende Kernresonanzmessungen in definierten Bereichen organischen Gewebes von in einem homogenen Magnetfeld befindlichen menschlichen oder tierischen Körpern, mit einer auf den Körper aufsetzbaren Hochfrequenz-Sende- und Empfangseinrichtung.

Ein Messkopf der eingangs genannten Art ist in einem Aufsatz von Alger et al. in der Zeitschrift «Science», Vol. 214, 6. November 1981, S. 660 bis 662 beschrieben.

Unter «definierten Bereichen» sollen im folgenden kleine Oberflächenbereiche oder oberflächennahe Bereiche der Körper verstanden werden, und zwar im Gegensatz zu den bekannten Ganzkörper-Messungen, wie man sie in der Kernspintomographie kennt. Die Grösse des «definierten Bereiches» wird dabei im wesentlichen von der Geometrie des jeweils verwendeten Messkopfes bestimmt, weil Messungen nur in der Nähe der Aufsetzebene des Messkopfes auf den Körper vorgenommen werden.

Es ist bekannt, das Untersuchungsverfahren der Kernresonanz und auch der hochauflösenden Kernresonanz für diagnostische Zwecke einzusetzen. Dabei wird stets ein zu untersuchender Körper oder Körperteil eines Patienten in ein Magnetsystem eingebracht, das in einem makroskopischen Bereich des Körpers oder Körperteils ein hinreichend homogenes Konstantmagnetfeld erzeugt.

Zum Anregen der Kernresonanz muss in senkrechter Richtung zum Konstantmagnetfeld nun noch ein Hochfrequenzmagnetfeld einer Frequenz eingestrahlt werden, die für unterschiedliche Kernarten im Verhältnis zur Stärke des Konstantmagnetfeldes als Naturkonstante feststeht.

Bei den sogenannten Kernspintomographen wird das Hochfrequenzmagnetfeld durch grosse sattelförmige Spulen erzeugt, so dass die in der Kernspintomographie gewünschten Querschnittsbilder von Patientenkörpern oder Körperteilen erzeugt werden können.

Eine derartige grossräumige Erzeugung von Hochfrequenzmagnetfeldern kann es jedoch einmal mit sich bringen, dass der Körper oder Körperteil des Patienten durch die Hochfrequenzeinstrahlung zu sehr erwärmt wird, andererseits haben die grossräumigen Hochfrequenz-Anordnungen den Nachteil, dass bei hohen Hochfrequenzfeldstärken einerseits Störstrahlung nach aussen dringen kann, die in der Nähe befindliche Messgeräte stört und andererseits auch Störstrahlung von aussen in die Sattelspulenanordnung eindringen und Verfälschungen des Messergebnisses hervorrufen können.

Es ist daher, beispielsweise aus dem eingangs genannten Zeitschriftenartikel, bekannt, anstelle von grossräumigen Sattelspulen kleine Oberflächenspulen zu verwenden, die auf einen interessierenden Bereich des Körpers aufgelegt werden. Für tieferliegende Organe wird bei Tierversuchen z.B. das zu untersuchende Organ (Leber) freigelegt und die Spule auf das Organ gelegt. Häufig sind jedoch nur die Oberflächenbereiche oder wenigstens die oberflächennahen Bereiche des zu untersuchenden Körpers von Interesse, so dass die kleinen Oberflächenspulen-Anordnungen ausreichend sind, die weder durch übermässige Hochfrequenzeinstrahlung den Patienten beeinträchtigen können noch übermässige Störstrahlungen abstrahlen oder gegenüber Störeinstrahlungen empfindlich sind.

Derartige Oberflächenspulen werden daher stets dann verwendet, wenn eine Entnahme von Probensubstanz nicht möglich ist und mit verhältnismässig geringem Aufwand am lebenden Körper (sogenannte In-Vivo-Messung) gemessen werden soll und wenn andererseits eine Einbringung des gesamten Körpers oder Körperteils in einen Probenkopf nicht erwünscht oder möglich ist.

Aus einem Aufsatz von Volino et al. in «Review of Scientific Instruments», Band 39, Nr. 11, 1968, S. 1660 bis 1665 sind Helix-Resonatoren für Elektronenspinresonanz-Messungen bekannt, die im Mikrowellenbereich (X-Band) ausgeführt werden. Bei diesen Messungen wird ein Probenröhrchen, das den gesamten Innenraum der Helix ausfüllt verwendet, es kann aber auch die Helix insgesamt in eine Flüssigkeit eingetaucht werden. Aufgrund der sich in der Helix ausbreitenden Wanderwelle ist praktisch der gesamte Innenraum der Helix mit Komponenten des elektrischen Feldes ausgefüllt, so dass das Einführen einer Probe eine drastische Verminderung der ohnehin schon niedrigen Güte des Helix-Resonators mit sich bringt. Die Güte der leeren Helix liegt nämlich schon eine Grössenordnung unter derjenigen von üblichen Hohlraumresonatoren, und der sich demzufolge einstellende Verlust an Empfindlichkeit kann beim Helix-Resonator nur teilweise dadurch kompensiert werden, dass durch vollständiges Füllen des Innenraumes der Helix der Füllfaktor, verglichen mit einem Hohlraumresonator, erhöht wird. In jedem Falle ist es bei einem Helix-Resonator dieser Art erforderlich, den gesamten Innenraum der Helix mit Probenmaterial zu füllen. Diese Möglichkeit besteht bei In-Vivo-Messungen am lebenden Körper jedoch nicht. Ausserdem ist bei dem bekannten Helix-Resonator eine Ausnutzung des Aussenfeldes nicht vorgesehen und eine Trennung von Bereichen magnetischen und elektrischen Feldes weder vorgesehen, noch — für die hier interessierenden Proben mit endlichen Abmessungen — überhaupt möglich.

Aus einem Aufsatz von Fisk in der Zeitschrift QST, Juni 1976, S. 11 bis 14, ist es bekannt, für Amateurfunkzwecke Helix-Resonatoren zu verwenden, bei denen die Helix von einer koaxialen Abschirmung umgeben ist, die an beiden Enden offen sein kann. Bei diesen, ausschliesslich als Filter vorgesehenen Resonatoren, die demzufolge weder über «Sende-», noch «Empfangseigenschaften» verfügen, wird jedoch, wie in der Funktechnik üblich, besonderer Wert darauf gelegt, dass keinerlei Feldlinien in den Aussenbereich des Resonators dringen. Hierzu wird entweder die Abschirmung an beiden Enden mit einem leitenden Boden verschlossen, so dass sich die Helix in einem allseits geschlossenen leitenden Gehäuse befindet, oder es wird die koaxiale Abschirmung axial so weit über die Enden der Helix hinaus verlängert, dass nur noch vernachlässigbare Komponente des Streufeldes der Helix nach aussen dringen. Damit ist eine Anwendung bei Oberflächenmessungen der eingangs genannten Art nicht möglich, weil bei diesen bekannten Helix-Resonatoren bestimmungsgemäss keinerlei Feldlinien nach aussen dringen und auch nicht dringen dürfen. Auch sind naturgemäss keine Vorkehrungen getroffen, um Bereich hoher magnetischer und niedriger elektrischer Feldstärke zu schaffen.

Betrachtet man Oberflächenspulen für Kernresonanzmessungen der eingangs genannten Art näher, erkennt man, dass diese Oberflächenspulen mehrere systematische Nachteile aufweisen:

Ein wesentlicher Nachteil besteht darin, dass bei derartigen einfachen Oberflächenspulen keine räumliche Trennung zwischen elektrischem und magnetischem Feld besteht. Der zu untersuchende Körperbereich braucht zur Anregung von Kernresonanzen jedoch nur mit dem magnetischen Hochfrequenzfeld, nicht jedoch mit dem elektrischen Hochfrequenzfeld beaufschlagt zu werden, dies ist sogar deswegen unerwünscht, weil aufgrund dielektrischer Verluste im Körper eine Beeinträchtigung der Empfindlichkeit des Messkopfes eintritt.

Ein weiterer Nachteil der Oberflächenspulen ist der, dass sie relativ schmalbandig sind, so dass zur Anregung unterschiedlicher Kernarten jeweils getrennte Messköpfe mit unterschiedlichen Oberflächenspulen verwendet werden müssen. Beim Wechsel des Probenkopfes tritt jedoch in aller Regel, insbesondere bei unruhigen Patienten, auch ein Wechsel des Messortes ein, so dass bei aufeinanderfolgenden Messungen mehrerer Kernarten unter Umständen nicht mehr vergleichbare Messergebnisse erzielt werden. Aufgrund dessen ist es auch nicht möglich, bei einer ersten Kernart mit verhältnismässig starken Kernresonanzsignalen zunächst einen Abgleich der Apparatur vorzunehmen und alsdann bei einer anderen Kernart das eigentlich interessierende Kernresonanzspektrum aufzunehmen.

Die bekannten Oberflächenspulen haben ferner den Nachteil, dass sie trotz ihrer geringeren Abmessungen, verglichen mit den eingangs genannten Sattelspulen, immer noch eine gewisse Restabstrahlung und damit auch eine Empfindlichkeit gegenüber Störeinstrahlung aufweisen.

Es ist bekannt, dass bei der üblichen Kernspintomographie, d.h. der Bilddarstellung von Körperquerschnitten, eine Homogenität des Konstantmagnetfeldes von $10^{-5}$ ausreicht, während bei der eingangs genannten Verwendung von aufgesetzten Messköpfen zur Aufnahme hochaufgelöster Kernresonanzspektren eine Homogenität von mindestens $10^{-7}$ erforderlich ist. Es ist daher erforderlich, bei Aufnahme derartiger hochaufgelöster Kernresonanzspektren vor Beginn der Messung das Konstantmagnetfeld am Messort, das heisst im zu untersuchenden Bereich des Patientenkörpers oder Körperteils sorgfältig homogen einzustellen. Diese Einstellung sollte möglichst rasch möglich sein, um den Patienten keine überlange Untersuchungsdauer zuzumuten und um eine wirtschaftlich ausreichende Auslastung der Apparatur zu ermöglichen.

Es ist schliesslich bekannt, dass man die Aussagekraft von Kernresonanzspektren dadurch erhöhen kann, dass man bei Messung einer Kernart eine andere Kernart «entkoppelt», das heisst gleichzeitig durch ein starkes Hochfrequenzfeld anregt bzw. sättigt. Üblicherweise werden Protonen entkoppelt und andere Kernarten gemessen. Zur Entkopplung sind jedoch hohe Hochfrequenzleistungen erforderlich, so dass bei den eingangs genannten bekannten Anordnungen mit Sattelspulen und aufgesetzten Flächenspulen eine erhöhte Gefahr von Störungen elektrischer Natur besteht. Es ist daher wünschenswert, auch bei aufgesetzten Messköpfen derartige entkoppelte Experimente durchführbar zu machen.

Der Erfindung liegt daher die Aufgabe zugrunde, Messungen der eingangs genannten Art zu ermöglichen, bei denen der interessierende Körperbereich praktisch ausschliesslich vom magnetischen Hochfrequenzfeld durchsetzt wird, ferner unterschiedliche Kernarten ohne Wechsel eines Messkopfes gemessen werden können und schliesslich nur ein Minimum an Störstrahlung abgegeben wird, wodurch die Messungen gegenüber Störeinstrahlung von aussen weitgehend unempfindlich sind.

Diese Aufgabe wird erfindungsgemäss durch einen Messkopf gelöst, bei dem die Einrichtung als Wendelleitung mit koaxialer Abschirmung ausgebildet ist, die Abschirmung an mindestens ihrem oberen Ende offen und das andere Ende der Wendelleitung anschlussfrei ist und schliesslich die oberste mit der Abschirmung über einen Anschluss verbundene Windung der Wendelleitung sich etwa in der Ebene des oberen offenen Endes befindet und dort die Aufsetzebene bildet.

Der erfindungsgemässe Messkopf hat damit den Vorteil, dass die Wendelleitung überwiegend magnetische Feldlinien nach aussen dringen lässt, während die elektrischen Feldlinien sich überwiegend zwischen der Wendelleitung und der Abschirmung, das heisst in deren Innenraum schliessen und damit nur in untergeordnetem Umfange nach aussen wirksam werden. Die elektrischen Verluste im untersuchten Körperbereich treten damit nur in sehr geringem Umfange auf. Ein weiterer Vorteil ist, dass eine Wendelleitung von ihrer Struktur her in mehreren Schwingungsmoden bei unterschiedlicher Frequenz anregbar ist, so dass der erfindungsgemässe Messkopf in einem breiten Frequenzbereich einsetzbar ist, der das Anregen von Kernresonanzen unterschiedlicher Kernarten möglich macht, ohne dass es erforderlich ist, den Messkopf auszutauschen. Es können daher mit einmal auf den Körper aufgesetztem Messkopf in unmittelbarer zeitlicher Folge Kernresonanzspektren unterschiedlicher Kernarten aufgenommen werden. Damit ist einmal sichergestellt, dass für die Spektren unterschiedlicher Kernarten exakt dieselben Körperbereiche erfasst werden und dass zum anderen die gesamte Messung innerhalb kürzester Zeit abgeschlossen werden kann. Dieser letztgenannte Vorteil bringt auch erhebliche wirtschaftliche Vorteile mit sich, weil medizinisch-diagnostische Kernresonanzapparate sehr teuer in der Anschaffung sind und daher ein grosses Interesse darin besteht, die Kosten für eine derartige Apparatur durch eine möglichst grosse Anzahl von Messungen zu amortisieren.

Durch geeignete Dimensionierung des erfindungsgemässen Messkopfes kann dieser z.B. in einen chirurgisch geöffneten Körper eingeführt und auf ein freigelegtes Organ aufgelegt werden. Auch kann z.B. im Tierversuch ein Organ so freigelegt werden, dass es oben auf einen Messkopfdeckel aufgelegt werden kann.

Schliesslich hat der erfindungsgemässe Messkopf noch den wesentlichen Vorteil, dass aufgrund der die Wendelleitung umgebenden Abschirmung einerseits praktisch keine Störstrahlung nach aussen dringt, insbesondere auch deswegen, weil sich die elektrischen Feldlinien innerhalb der Abschirmung schliessen und dass in entsprechender Weise auch keine von aussen eindringende Störstrahlung die Messergebnisse verfälschen kann, weil insbesondere eine von aussen wirkende elektrische Ankopplung der geschlossenen Feldlinien innerhalb der Abschirmung praktisch nicht möglich ist.

Das von der Aufsetzebene abgewandte Ende der Wendelleitung kann unterschiedlich ausgebildet sein. Bei einer sogenannten $\lambda/2$-Anordnung läge beispielsweise eine klappsymmetrische Struktur vor, bei der das der Aufsetzebene entgegengesetzte Ende identisch mit der Aufsetzebene ausgebildet wäre. Es ist jedoch eine Ausführungsform bevorzugt, bei der eine sogenannte $\lambda/4$-Struktur verwendet wird und in der folglich das untere Ende der koaxialen Abschirmung geschlossen ist. Diese Ausführungsform ist deswegen besonders vorteilhaft, weil eine weitere Verbesserung der Abschirmeigenschaften durch das Schliessen der Abschirmung am entgegengesetzten Ende eintritt. Ausserdem ist diese Anordnung in axialer Richtung besonders kurz, was deswegen von besonderem Vorteil ist, weil der erfindungsgemässe Messkopf senkrecht zur Richtung des Konstantmagnetfeldes, das heisst senkrecht zur Achse eines Solenoid-Magnetsystems auf den zu untersuchenden Körper aufgesetzt werden muss. In dieser Koordinatenrichtung senkrecht zur Achse des Konstantmagnetfeldes ist jedoch im Inneren des Solenoid-Magnetsystems verhältnismässig wenig Raum.

Weiterhin ist eine Ausführungsform bevorzugt, bei der das die Aufsatzebene bildende offene Ende mit einem Deckel aus elektrisch nichtleitendem Material bedeckt ist, wobei der Deckel mit einer Vielzahl radial verlaufender Leiterbahnen versehen ist, deren äussere Enden in ein die Abschirmung bildendes Gehäuse übergehen und deren innere Enden im Bereich des Zentrums des Deckels zusammenlaufen, ohne einander zu berühren.

Diese Massnahme hat den Vorteil, dass das geringe noch verbleibende elektrische Hochfrequenzstreufeld oberhalb der Aufsetzebene durch die Leiterbahnen kurzgeschlossen wird. Dies ergibt eine weitere Verminderung der dielektrischen Verluste im Messkörper sowie eine weitere Verminderung der Störungen durch abgestrahlte bzw. eingefangene Störstrahlung.

Erfindungsgemäss ist ferner eine erste Abstimmanordnung vorgesehen, bei der der Abstand des freien Endes der Wendelleitung von dem anderen geschlossenen Ende der koaxialen Abschirmung variierbar ist.

Diese Massnahme hat den Vorteil, dass in besonders einfacher Weise die Abstimmung auf die gewünschte Resonanzfrequenz bei Anwendung eines $\lambda/4$-Resonators, das heisst bei niedrigst möglicher Resonanzfrequenz des Grund-Schwingungsmodes möglich ist. Dabei wird am «offenen Ende» durch Annähern einer Metallscheibe, insbesondere eines der radialen Querschnittsformen der Abschirmung entsprechenden Bodens, eine Abstimmung vorgenommen. Es versteht sich dabei, dass anstelle der Annäherung der Metallscheibe auch ein Eintauchen eines Metallzylinders oder ein Zuschalten eines Kondensators als konzentriertes Bauelement möglich ist, wie dies an sich bekannt ist.

Eine weitere bevorzugte Ausführungsform der Erfindung besteht darin, dass eine weitere Abstimmanordnung vorgesehen ist, bei der das von der Wendelleitung erzeugte elektrische Feld an einem axial definierten Ort belastet wird, an dem das elektrische Feld nur bei _einem_ vorbestimmten Schwingungsmodus ein Maximum aufweist.

Diese Massnahme hat den besonderen Vorteil, dass eine Frequenzabstimmung der einzelnen Schwingungsmoden unabhängig voneinander möglich ist. Ein Schwingungsmodus einer höheren Frequenz weist beispielsweise mehrere Maxima der elektrischen Feldstärke auf, das heisst also auch Maxima an Orten, an denen ein Schwingungsmodus niedrigerer Frequenz keine Maxima aufweist. Durch Belastung am Orte dieser nur bei Schwingungsmoden höherer Frequenz auftretenden Maxima kann die Frequenz des höheren Schwingungsmodus beispielsweise vermindert werden, ohne dass hierdurch die Resonanzfrequenz des niedrigeren Schwingungsmodus beeinflusst wird. Auf diese Weise ist es möglich, das Verhältnis der Frequenzen der verschiedenen Schwingungsmoden abweichend von den sich theoretisch ergebenden ungeradzahligen Vielfachen so einzustellen, dass sich unterschiedliche Resonanzfrequenzen im Messkopf ergeben, die den Kernresonanz-Frequenzen unterschiedlicher Kernarten entsprechen, wobei das Frequenzverhältnis unterschiedlicher Kernarten eine Naturkonstante ist und bekanntlich nicht ungeradzahligen Vielfachen entspricht.

Zweckmässigerweise kann die Abstimmanordnung dann so ausgebildet sein, dass sie zwischen der Wendelleitung und der Abschirmung angeordnet ist, derart, dass sie aus einer elektrisch leitenden Fahne besteht, deren eines Ende mit einem die Abschirmung bildenden Gehäuse verbunden und deren anderes Ende radial auslenkbar ist. Auf diese Weise kann eine Belastung eines Maximums der elektrischen Feldstärke durch einfaches Verdrehen einer Schraube erfolgen.

Eine weitere Möglichkeit für eine derartige selektive Abstimmung eines Maximums der elektrischen Feldstärke besteht darin, dass die Abstimmanordnung im Innenraum der Wendelleitung angeordnet ist, bevorzugt derart, dass sie aus einer offenen, einseitig mit einem die Abschirmung bildenden Gehäuse verbundenen Schleife mit quer zur Achse der Wendelleitung angeordneter Ebene besteht.

Diese letztgenannte Abstimmanordnung eignet sich besonders zum Einstellen einer fest vorgegebenen Grundbelastung.

Zur Optimierung der Anpassung des Messkopfes an die Zuleitung ist eine Ausführungsform bevorzugt, bei der in der Verbindung von Wendelleitung und Abschirmung eine weitere Abstimmanordnung, bevorzugt in Form eines einstellbaren Kondensators, vorgesehen ist. Diese Massnahme hat den Vorteil, dass die Zuleitung, die isoliert durch das Abschirmgehäuse hindurchgeführt wird, am offenen Ende der Wendelleitung unmittelbar angelötet werden kann und die Feinabstimmung der Ankopplung dann über den einstellbaren Kondensator erfolgt, so dass eine exakte Anpassung auf beispielsweise 50 Ω Wellenwiderstand möglich ist.

In weiterer bevorzugter Ausgestaltung der Erfindung ist die Wendelleitung mit einem Hochfrequenzsender einstellbarer Amplitude verbunden.

Diese Massnahme hat den folgenden überraschenden Vorteil:

Diejenigen Feldlinien des magnetischen Hochfrequenzfeldes, die vom offenen Ende des Messkopfes ausgehend in den zu untersuchenden Körper eintreten, führen zu einer Feldstärkeverteilung des hochfrequenten Magnetfeldes im zu untersuchenden Körper, bei der die Intensität des magnetischen Hochfrequenzfeldes von der Oberfläche des Körpers nach innen abnimmt. Durch Einstellen der Amplitude des magnetischen Hochfrequenzfeldes kann nun bewirkt werden, dass in definierter Tiefe unterhalb der Oberfläche des zu untersuchenden Körpers eine magnetische Hochfrequenzfeldstärke desjenigen Betrages vorliegt, bei der exakt die sogenannte 90°-Bedingung erfüllt ist, das heisst eine maximale Signalausbeute vorliegt, weil die Spins der zu untersuchenden Kernart bei Anlegen des magnetischen Hochfrequenzfeldes um 90° aus ihrer Ruhelage herausgedreht werden. Andere Bereiche des zu untersuchenden Körpers werden hingegen mit einem magnetischen Hochfrequenzfeld beaufschlagt, das in etwa der sogenannten 180°-Bedingung genügt, so dass von diesen Bereichen so gut wie kein Signal ausgeht.

Demzufolge kann durch Einstellen der Amplitude des magnetischen Hochfrequenzfeldes eine Selektion des untersuchten Körperabschnittes in der Tiefe vorgenommen werden.

Weitere Vorteile ergeben sich aus der Beschreibung und der beigefügten Zeichnung.

Die Erfindung ist in der Zeichnung dargestellt und wird in der nachfolgenden Beschreibung näher erläutert. Es zeigen:

Fig. 1 eine schematische räumliche Darstellung einer Spektrometeranordnung, in der der erfindungsgemässe Messkopf Verwendung findet;

Fig. 2 eine Prinzipdarstellung eines erfindungsgemässen Messkopfes im Querschnitt zur Erläuterung der sich einstellenden Feldverteilung;

Fig. 3 eine Schnittdarstellung eines praktischen Ausführungsbeispiels eines erfindungsgemässen Messkopfes in Verbindung mit den erforderlichen elektronischen Auswertegeräten;

Fig. 4 eine Ansicht des Ausführungsbeispiels gemäss Fig. 3 von oben in der Ebene I-II;

Fig. 5 eine Draufsicht auf das in Fig. 3 dargestellte Ausführungsbeispiel eines erfindungsgemässen Messkopfes.

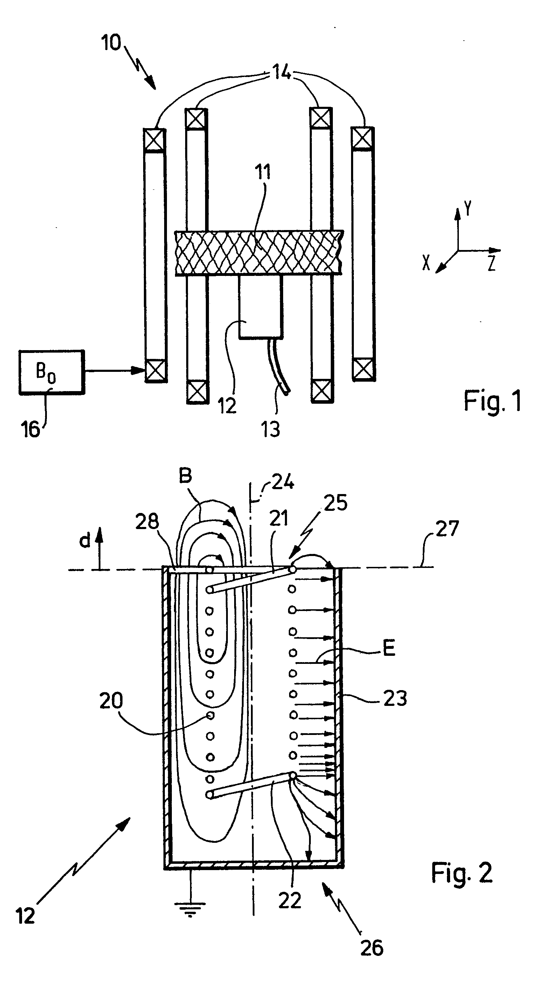

In Fig. 1 bezeichnet 10 insgesamt ein Magnetsystem, das in einem Raum mit den Raumkoordinaten x, y, z angeordnet ist. Die Raumkoordinate z fällt mit der Achse des Magnetsystems 10 zusammen. In der Achse z befindet sich ein schematisch angedeuteter Messkörper 11, beispielsweise gesamthaft ein Körper eines Patienten oder ein Körperteil, beispielsweise ein Arm oder ein Bein. Es versteht sich jedoch, dass der erfindungsgemässe Messkopf auch bei nichtorganischen Proben sowie bei Einzelproben von lebendem oder nichtlebendem Gewebe Verwendung finden kann.

Vom Messkopf 12 führt eine Zuleitung 13 zu einer in Fig. 1 nicht dargestellten Elektronik.

Das Magnetsystem 10 ist lediglich schematisch angedeutet und besteht aus einer sogenannten doppelten Helmholtz-Anordnung mit zwei Paaren von Helmholtz-Spulen 14. Die Helmholtz-Spulen 14 erzeugen im Inneren ein Konstantmagnetfeld hoher Homogenität in allen drei Raumkoordinaten x, y, z. Dies bedeutet, dass bei gleichzeitiger Einstrahlung eines magnetischen Hochfrequenzfeldes auf den Messkörper 11 in einer Richtung senkrecht zur Koordinate z eine Kernresonanz im gesamten Homogenitätsbereich eintreten würde.

Fig. 2 zeigt die Feldverteilung in einem erfindungsgemässen Messkopf 12.

Der Messkopf 12 besteht im wesentlichen aus einer Wendelleitung 20, wie sie in der Fachliteratur auch als «Helix» bezeichnet wird. Von der Wendelleitung 20 sind der Übersichtlichkeit halber in Fig. 2 nur die oberste Windung 21 und die unterste Windung 22 vollständig dargestellt. Das zweite wesentliche Element des erfindungsgemässen Messkopfes 12 ist eine geerdete Abschirmung 23, die sich z.B. in einer Ausführungsform koaxial um die Wendelleitung 20 herum erstreckt. Die Abschirmung 23 mit einer Längsachse 24 weist ein oberes offenes Ende 25 sowie ein unteres geschlossenes Ende 26 auf. Beim Ausführungsbeispiel gemäss Fig. 2 ist die Lage der Wendelleitung 20 in der Achse 24 derart, dass die oberste, mit der Abschirmung 23 über einen Anschluss 28 verbundene Windung 21 sich etwa in der Ebene des oberen offenen Endes 25 befindet und dort eine Aufsetzebene 27 bildet, das heisst eine Ebene, in der der Messkopf 12 auf den zu untersuchenden Messkörper 11 aufgesetzt wird.

Elektrisch gesehen bedeutet dies, dass die Wendelleitung 20 am oberen offenen Ende 25 mit der Abschirmung 23 über den Anschluss 28 mit Masse verbunden ist, während sie im Bereich ihrer untersten Windung 22 im Abstand vom unteren geschlossenen Ende 26 der Abschirmung 23 elektrisch offen ist.

Damit ergibt sich eine Feldverteilung, wie sie in Fig. 2 in der Hälfte links von der Achse 24 für die magnetischen Feldlinien mit B und in der Hälfte rechts von der Achse 24 für die elektrischen Feldlinien mit E bezeichnet ist. Man erkennt, dass sich die magnetischen Feldlinien B in einer Radialebene der Wendelleitung 20 schliessen und insbesondere oberhalb des oberen offenen Endes 25 in den freien Raum hinein erstrecken. Setzt man den Messkopf 12 in der Aufsetzebene 27 auf den Messkörper 11 auf, ergibt sich damit eine Verteilung der magnetischen Feldlinien B, derart, dass die Intensität des Magnetfeldes längs einer Koordinate d in Fig. 2 zum Inneren des Messkörpers 11 hin abnimmt.

Die elektrischen Feldlinien E hingegen verlaufen im wesentlichen im Zwischenraum zwischen Wendelleitung 20 und Abschirmung 23, so dass sie nach aussen hin praktisch nicht in Erscheinung treten. Im Bereich oberhalb der Aufsetzebene 27 sind kaum Streufelder der elektrischen Feldlinien E zu beobachten. Die E-Feldliniendichte nimmt ausserdem von unten nach oben ab.

Das elektrisch-schematische Bild gemäss Fig. 2 stellt einen sogenannten $\lambda/4$-Resonator dar, bei dem das untere Ende 26 der Abschirmung 23 geschlossen ist. Es versteht sich, dass anstelle der in Fig. 2 dargestellten Anordnung auch eine sogenannte $\lambda/2$-Anordnung Verwendung finden kann, bei der die Anordnung gemäss Fig. 2 etwa in der Ebene der untersten Windung 22 der Wendelleitung 20 in radialer Richtung abgeschnitten ist und an den verbleibenden oberen Teil der Anordnung gemäss Fig. 2 klappsymmetrisch ein identischer Teil nach unten angeschlossen wird, der dann nach unten in einer Konfiguration endet, die mit dem oberen offenen Ende 25 übereinstimmt. Wie man jedoch leicht erkennt, ist die Anordnung gemäss Fig. 2 mit einem $\lambda/4$-Resonator wesentlich kürzer und überdies nach unten vollständig abgeschirmt, so dass sie im allgemeinen für die Aufnahme von Kernresonanzspektren innerhalb eines Magnetsystems 10 zweckmässiger sein dürfte.

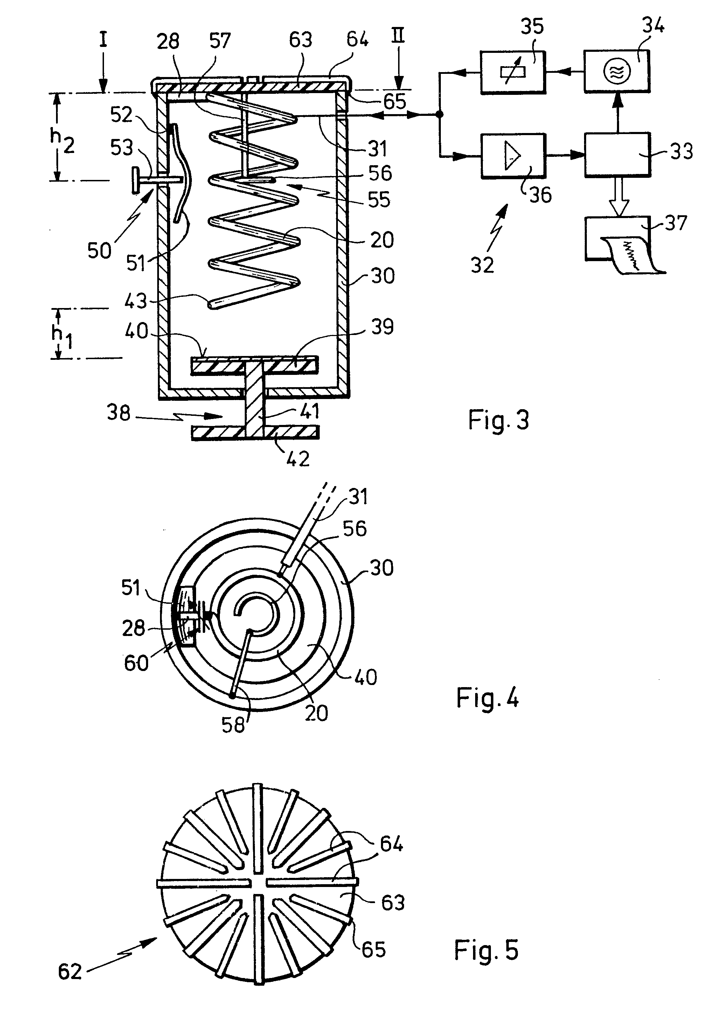

Fig. 3 zeigt eine praktische Ausführung eines Messkopfes 12, wie er in Fig. 2 bereits schematisch dargestellt wurde. Als Abschirmung 23 dient beim Ausführungsbeispiel gemäss Fig. 3 ein becherförmiges Gehäuse 30 aus leitendem Material. In der Nähe des oberen Randes des Gehäuses 30 ist isoliert eine Leitung 31 durch dessen Wand hindurchgeführt und an die Wendelleitung 20 angeschlossen, beispielsweise angelötet. Die Leitung 31 ist mit einer Messelektronik verbunden, die in Fig. 3 insgesamt mit 32 angedeutet ist. Zur Messelektronik 32 gehört zunächst ein Steuergerät 33, das die unterschiedlichen Sende- und Empfangsvorgänge, die Datenverarbeitung sowie die Ausgabe der Messergebnisse steuert. So steuert das Gerät 33 beispielsweise einen Hochfrequenzsender 34, dessen Ausgangsleistung über einen Abschwächer 35 oder eine regelbare Leistungs-Endstufe einstellbar ist. Hingegen ist im Empfangsteil ein Empfangsverstärker 36 vorgesehen, dessen Ausgang zum Steuergerät 33 führt. Schliesslich ist das Steuergerät 33 noch an einen Schreiber 37 oder ein ähnliches Anzeigegerät, beispielsweise einen Bildschirm, angeschlossen.

Wie man, insbesondere auch in Verbindung mit Fig. 4, erkennt, sind am erfindungsgemässen Messkopf 12 insgesamt vier Abstimmanordnungen vorgesehen.

Die erste Abstimmanordnung 38 besteht im wesentlichen aus einem Boden 39 aus elektrisch nichtleitendem Material, der jedoch mit einem elektrisch leitenden Belag 40 versehen ist. An der Unterseite des Bodens 39 befindet sich eine Gewindestange 41, die mit dem Belag 40 leitend verbunden ist und durch eine Gewindebohrung im Boden des Gehäuses 30 nach aussen zu einem Rad 42 führt, das von Hand gedreht werden kann, so dass durch Eindrehen der Gewindestange 41 in den Boden des Gehäuses 30 sich der elektrisch leitende Belag 40 des Bodens 39 in axialer Richtung des Gehäuses 30 bewegt. Der Abstand $h_1$ des elektrisch leitenden Belages vom unteren freien Ende 43 der Wendelleitung 20 führt zu einer Abstimmung der Resonanzfrequenz des Grundschwingungsmodes, das heisst der tiefsten Frequenz, bei dem der erfindungsgemässe Messkopf resonanzfähig ist.

Eine zweite Abstimmanordnung 50 besteht aus einer elektrisch leitfähigen Fahne 51, die mit ihrem einen Ende 52 elektrisch leitend mit der Innenseite des Gehäuses 30 verbunden, beispielsweise verlötet ist. Durch Eindrehen einer radial angeordneten Schraube 53 durch das Gehäuse 30 hindurch kann nun der mittlere Bereich bzw. das freie Ende der Fahne 51 in radialer Richtung ausgelenkt werden.

Die Schraube 53 befindet sich in einem Abstand $h_2$ von der Oberkante des Gehäuses 30.

Im gleichen Abstand $h_2$ von der Oberkante des Gehäuses 30 ist eine dritte Abstimmanordnung 55 wirksam, die aus einer offenen Schleife 56 in eine Radialebene zur Wendelleitung 20 besteht. Über eine axial verlaufende Leitung 57 und eine abgeknickte, radial verlaufende Leitung 58 ist die offene Schleife 56 fest mit der Innenseite des Gehäuses 30 verbunden, insbesondere verlötet, und damit geerdet.

Das aus der Wendelleitung 20 und dem Abschirmgehäuse 30 gebildete System ist bei unterschiedlichen Schwingungsmoden resonanzfähig. Neben dem bereits genannten Grundmodus gibt es noch eine Vielzahl höherer Schwingungsmoden mit entsprechend höherer Resonanzfrequenz. Bei diesen höheren Schwingungsmoden tritt eine Vielzahl von Maxima der elektrischen Feldstärke entlang der Längsachse des Gehäuses 30 bzw. der Wendelleitung 20 auf. Diese zusätzlichen Maxima sind jedoch bei niedrigen Schwingungsmoden, insbesondere dem Grundmodus nicht vorhanden. Der Abstand $h_2$ entspricht nun demjenigen Abstand, den ein Maximum der elektrischen Feldstärke in axialer Richtung von der Oberkante des Gehäuses 30 hat. Mittels der zweiten Abstimmanordnung kann nun das Maximum des höheren Schwingungsmodus durch Eindrehen der Schraube 53 kontinuierlich belastet werden, während die dritte Abstimmanordnung eine konstante Belastung darstellt. Durch eine oder beide der Abstimmanordnungen 50, 55 kann demzufolge die Resonanzfrequenz des höheren Schwingungsmodus so vermindert werden, dass sich zwischen der Resonanzfrequenz des höheren Schwingungsmodus und derjenigen des Grundmodus ein Verhältnis ergibt, das von dem theoretischen Wert eines ungeradzahligen Vielfachen abweicht. Das Verhältnis kann zum Beispiel so eingestellt werden, dass es dem Verhältnis der Resonanzfrequenzen unterschiedlicher Kernarten, beispielsweise von Protonen einerseits und dem Isotop $C^{13}$ des Kohlenstoffs andererseits entspricht, also etwa 80 MHz für $H^1$ und 20,1 MHz für $C^{13}$.

Wie bereits erwähnt, erfolgt die Ankopplung der Wendelleitung 20 über die gegenüber dem Gehäuse 30 isolierte Leitung 31, deren freies Ende an die oberste Windung 21 der Wendelleitung 20 angelötet ist. Wie man am besten aus Fig. 4 erkennt, sind der Anschlusspunkt der Leitung 31 und der Anschlusspunkt des Masseanschlusses 28 um einen bestimmten Winkel über den Umfang der obersten Windung 21 gegeneinander versetzt. Da mit der Definition dieses Winkels nur eine verhältnismässig grobe Abstimmung möglich ist, kann mit einer vierten Abstimmanordnung 60, die insbesondere aus einem einstellbaren Kondensator in der Zuleitung oder an der Stelle des Kurzschlusses bestehen kann, eine Feinabstimmung vorgenommen werden, so dass von aussen in die Leitung 31 hineingesehen ein definierter Abschlusswiderstand, beispielsweise ein Wellenwiderstand von 50 Ω, vorliegt. Es versteht sich, dass statt eines einzelnen Kondensators als vierte Abstimmanordnung 60 auch mehrere Kondensatoren in Parallelschaltung verwendet werden können, die für die verwendete Hochfrequenz praktisch einen Kurzschluss darstellen.

Schliesslich erkennt man aus Fig. 3 und Fig. 5 noch, dass das obere offene Ende 25 der Abschirmung 23 (vgl. Fig. 2) mit einem Deckel 62 verschlossen werden kann, der im wesentlichen aus einer Kunststoffplatte 63 besteht. Auf die Kunststoffplatte 63, die elektrisch nichtleitend ist, sind Leiterbahnen 64 aufgebracht, die, wie man aus Fig. 5 erkennt, einen sternförmigen, das heisst radialen Verlauf haben. Die Leiterbahnen 64 sind am äusseren Rand über Lötstellen 65 mit dem elektrisch leitenden Gehäuse 30 verbunden und erstrecken sich vom äusseren Rand nach innen zum Zentrum, ohne dieses zu erreichen oder einander zu berühren.

Betrachtet man die rechte Hälfte von Fig. 2 zusammen mit Fig. 5, erkennt man sofort, dass die Leiterbahnen 64 die in den Aussenraum der Abschirmung 23 noch hineinreichenden elektrischen Feldlinien E des Streufeldes kurzschliessen. Der Deckel 62 mit den Leiterbahnen 64 bewirkt daher, dass praktisch überhaupt kein elektrisches Streufeld oberhalb der Aufsetzebene 27 mehr auftreten kann.

Mit Hilfe des vorstehend im einzelnen erläuterten Messkopfes 12 kann in unterschiedlicher Weise gearbeitet werden:

Das grundsätzliche Messverfahren besteht darin, dass entsprechend Fig. 1 der Messkörper 11 in das Innere des Magnetsystems 10 gebracht und der Messkopf 12 aufgesetzt wird. Die magnetischen Feldlinien B entsprechend Fig. 2, linke Hälfte dringen nun in den Messkörper 11 ein und erzeugen, sofern sie senkrecht zur Koordinatenrichtung z verlaufen, Kernresonanzen. Durch geeignete Einstellung des Verhältnisses von Stärke des Konstantmagnetfeldes zu eingestrahlter Messfrequenz können unterschiedliche Kernarten angeregt werden.

Durch die auftretende Kernresonanz trifft eine Signalspannung im Hochfrequenzkreis des Messkopfes 12 ein, die im Empfangskreis mit dem Eingangsverstärker 36 der Elektronik 32 verstärkt und in entsprechende Spektrensignale umgewandelt wird, wie dies im einzelnen bekannt ist.

Durch Einstellen des Abschwächers 35 kann nun die Intensitätsverteilung des magnetischen Hochfrequenzfeldes innerhalb des Messkörpers 11 eingestellt werden in der Weise, dass in einer bestimmten Tiefe d unterhalb der Aufsetzebene 27 im Körper 11 eine Stärke des magnetischen Hochfrequenzfeldes vorliegt, bei der die gemessenen Spins gerade um 90° ausgelenkt werden. Man erkennt, dass durch Einstellen des Abschwächers 35 eine Selektion der Messebene in Richtung der Koordinate d erzielt werden kann.

Ein weiteres Messverfahren besteht darin, dass mittels der Abstimmanordnungen 38, 50 und 55 der Messkopf so abgeglichen wird, dass er sowohl bei einer höheren Frequenz, die beispielsweise Protonen entspricht, wie auch bei einer niedrigeren Messfrequenz, die beispielsweise $C^{13}$ entspricht, resonanzfähig ist.

Nun wird zunächst der Messkopf 12 auf den Messkörper 11 aufgesetzt und eine Protonen-Resonanz angeregt. Aufgrund der hohen Intensität von Protonen-Signalen kann das Protonen-Spektrum nach jeder einzelnen Anregung betrachtet werden. Durch in Fig. 1 nicht dargestellte Mittel zum Homogenisieren des Konstantmagnetfeldes, nämlich durch sogenannte Shim-Spulen mit zugehörigen Netzgeräten, kann das Konstantmagnetfeld unter gleichzeitiger Beobachtung des Protonen-Spektrums so nachgestellt werden, dass sich die Linienbreite im Protonen-Spektrum bis zu einem Minimalwert vermindert. Bei diesem Minimalwert ist die Homogenität des Konstantmagnetfeldes besonders gut. Nun wird, während der Messkopf 12 in seiner Aufsetzstellung am Messkörper 11 verbleibt, die Messelektronik 32 auf eine niedrigere Messfrequenz, die der Kernart $C^{13}$ entspricht, umgeschaltet. Die $C^{13}$-Messung wird demzufolge bei einer besonders guten Homogenität durchgeführt.

Schliesslich kann ein weiteres Messverfahren darin bestehen, dass der Messkopf 12 in Fig. 1 bei gleichzeitiger Anwesenheit von Hochfrequenz-Sattelspulen auf den Messkörper 11 aufgesetzt wird. Dabei stehen die magnetischen Feldlinien des Konstantmagnetfeldes, des Hochfrequenzfeldes vom Messkopf 12 sowie des Hochfrequenzfeldes von den Sattelspulen jeweils aufeinander senkrecht. Mittels der Hochfrequenz-Sattelspulen kann nun ein Entkopplungsfeld, beispielsweise für Protonen, auf den Messkörper 11 eingestrahlt werden, während mit dem Messkopf 12 selbst gleichzeitig beispielsweise ein (protonen-entkoppeltes) $C^{13}$-Kernresonanzspektrum aufgenommen wird. Aufgrund der senkrechten Orientierung der jeweiligen Hochfrequenz-Feldrichtungen von Entkopplungsfeld einerseits und Messfeld andererseits ergibt sich eine besonders niedrige Störeinstrahlung von den Hochfrequenz-Sattelspulen in den erfindungsgemässen Messkopf 12, insbesondere auch deshalb, weil die praktisch allseitige Abschirmung 23 zusätzlich für eine scharfe Trennung von Entkopplungskreis und Messkreis sorgt.

**Patentansprüche**

1. Messkopf für hochauflösende Kernresonanzmessungen in definierten Bereichen organischen Gewebes von in einem homogenen Konstantmagnetfeld befindlichen menschlichen oder tierischen Körpern (11) mit einer auf den Körper (11) aufsetzbaren Hochfrequenz-Sende- und Empfangseinrichtung, dadurch gekennzeichnet, dass die Einrichtung als Wendelleitung (20) mit koaxialer Abschirmung (23) ausgebildet ist, dass die Abschirmung (23) an mindestens ihrem oberen Ende (25) offen und das untere Ende der Wendelleitung (20) anschlussfrei ist und dass die oberste, mit der Abschirmung (23) über einen Anschluss (28) verbundene Windung (21) der Wendelleitung (20) sich etwa in der Ebene des oberen offenen Endes (25) befindet und dort die Aufsetzebene (27) bildet.

2. Messkopf nach Anspruch 1, dadurch gekennzeichnet, dass das untere Ende (26) der Abschirmung (23) geschlossen ist, so dass der Messkopf (12) einen λ/4-Resonator bildet.

3. Messkopf nach einem der Ansprüche 1 oder 2, dadurch gekennzeichnet, dass das die Aufsetzebene (27) bildende offene Ende (25) mit einem Deckel (62) aus elektrisch nichtleitendem Material bedeckt ist, wobei der Deckel (62) mit einer Vielzahl radial verlaufender Leiterbahnen (64) versehen ist, deren äusseres Ende in ein die Abschirmung (23) bildendes Gehäuse (30) übergehen und deren innere Enden im Bereich des Zentrums des Deckels (62) zusammenlaufen, ohne einander zu berühren.

4. Messkopf nach Anspruch 2 oder 3, dadurch gekennzeichnet, dass eine erste Abstimmanordnung (38) vorgesehen ist, bei der der elektrische Abstand $h_1$ des freien Endes (43) der Wendelleitung (20) von dem anderen Ende (26) der geschlossenen koaxialen Abschirmung (23) variierbar ist.

5. Messkopf nach Anspruch 4, dadurch gekennzeichnet, dass die erste Abstimmanordnung (38) aus einem mit einem leitfähigen Belag (40) versehenen, der radialen Querschnittsform der Abschirmung (23) entsprechenden Boden (39) besteht, der in ein die Abschirmung (23) bildendes Gehäuse (30) einschraubbar ist.

6. Messkopf nach einem der Ansprüche 1 bis 5, dadurch gekennzeichnet, dass eine weitere Abstimmanordnung (50, 55) vorgesehen ist, bei der das von der Wendelleitung (20) erzeugte elektrische Feld E an einem axial definierten Ort belastet wird, an dem das elektrische Feld E nur bei einem vorbestimmten Schwingungsmodus ein Maximum aufweist.

7. Messkopf nach Anspruch 6, dadurch gekennzeichnet, dass eine zweite Abstimmanordnung (50) zwischen der Wendelleitung (20) und der Abschirmung (23) angeordnet ist, wobei die zweite Abstimmanordnung (50) aus einer elektrisch leitfähigen Fahne (51) besteht, deren eines Ende (52) mit einem die Abschirmung (23) bildenden Gehäuse (30) verbunden und deren anderes Ende radial auslenkbar ist.

8. Messkopf nach Anspruch 6, dadurch gekennzeichnet, dass eine dritte Abstimmanordnung (55) im Innenraum der Wendelleitung (20) angeordnet ist.

9. Messkopf nach Anspruch 8, dadurch gekennzeichnet, dass die dritte Abstimmanordnung (55) aus einer offenen, einseitig mit einem die Abschirmung (23) bildenden Gehäuse (30) verbundenen Schleife (56) mit quer zur Achse der Wendelleitung (20) angeordneten Ebene besteht.

10. Messkopf nach einem der Ansprüche 1 bis 9, dadurch gekennzeichnet, dass eine vierte Abstimmanordnung (60) in der Verbindung (28) von Wendelleitung (20) und Abschirmung (23) angeordnet ist.

11. Messkopf nach Anspruch 10, dadurch gekennzeichnet, dass die vierte Abstimmanordnung (60) von einem einstellbaren Kondensator gebildet ist.

12. Messkopf nach einem der Ansprüche 1 bis 11, dadurch gekennzeichnet, dass die Wendelleitung (20) mit einem Hochfrequenzsender (34) einstellbarer Amplitude verbunden ist.

## Claims

1. Measuring head for high-resolution nuclear resonance measurements in defined regions of organic tissue of human or animal bodies (11) situated in a homogeneous constant magnetic field, having a high-frequency emitting and receiving device which can be placed on the body (11), characterized in that the device is constructed as a helical conductor (20) with a coaxial screen (23), in that the screen (23) is open at at least its upper end (25) and the lower end of the helical conductor (20) has no connection, and in that the uppermost winding (21) of the helical conductor (20), which winding is connected to the screen (23) via a connection (28), is situated approximately in the plane of the upper open end (25) and there forms the placing-on plane (27).

2. Measuring head according to Claim 1, characterized in that the lower end (26) of the screen (23) is closed, so that the measuring head (12) forms a λ/4 resonator.

3. Measuring head according to one of Claims 1 or 2, characterized in that the open end (25) forming the placing-on plane (27) is covered with a cover (62) of electrically non-conductive material, the cover (62) being provided with a plurality of radially extending conducting paths (64), the outer ends of which merge into a housing (30) forming the screen (23) and the inner ends of which run together in the region of the centre of the cover (62), without touching one another.

4. Measuring head according to Claim 2 or 3, characterized in that a first tuning arrangement (38) is provided, in which the electrical spacing $h_1$ of the free end (43) of the helical conductor (20) from the other end (26) of the closed coaxial screen (23) is variable.

5. Measuring head according to Claim 4, characterized in that the first tuning arrangement (38) consists of a base (39), which is provided with a conductive covering (40) and which corresponds to the radial cross-sectional shape of the screen (23) and which can be screwed into a housing (30) forming the screen (23).

6. Measuring head according to one of Claims 1 to 5, characterized in that a further tuning arrangement (50, 55) is provided, in which the electric field E generated by the helical conductor (20) is applied at an axially defined location, at which the electric field E exhibits a maximum only in a predetermined oscillation mode.

7. Measuring head according to Claim 6, characterized in that a second tuning arrangement (50) is disposed between the helical conductor (20) and the screen (23), the second tuning arrangement (50) consisting of an electrically conductive vane (51), one end (52) of which is connected to a housing (30) forming the screen (23) and the other end of which can be deflected out radially.

8. Measuring head according to Claim 6, characterized in that a third tuning arrangement (55) is disposed in the interior space of the helical conductor (20).

9. Measuring head according to Claim 8, characterized in that the third tuning arrangement (55) consists of an open loop (56), connected at one end to a housing (30) forming the screen (23), with a plane disposed transversely to the axis of the helical conductor (20).

10. Measuring head according to one of Claims 1 to 9, characterized in that a fourth tuning arrangement (60) is disposed in the connection (28) of helical conductor (20) and screen (23).

11. Measuring head according to Claim 10, characterized in that the fourth tuning arrangement (60) is formed by an adjustable capacitor.

12. Measuring head according to one of Claims 1 to 11, characterized in that the helical conductor (20) is connected to a high-frequency emitter (34) of adjustable amplitude.

**Revendications**

1. Tête de mesure pour effectuer des mesures par résonance magnétique nucléaire à haute résolution dans des régions définies de tissu organique de corps (11) humains ou animaux se trouvant dans un champ magnétique constant et homogène, comprenant un dispositif d'émission et de réception à haute fréquence conçu pour être posé sur le corps (11), caractérisée en ce que le dispositif est réalisé comme une ligne hélicoïdale (20) avec un blindage coaxial (23), que le blindage (23) est ouvert au moins à son extrémité supérieure (25) et l'extrémité inférieure de la ligne hélicoïdale (20) ne présente pas de connexion et que la spire supérieure (21) de la ligne hélicoïdale (20), reliée par une connexion (28) au blindage (23), est située à peu près dans le plan de l'extrémité supérieure ouverte (25) et y forme le plan de pose (27) ou d'application contre le corps.

2. Tête de mesure selon la revendication 1, caractérisée en ce que l'extrémité inférieure (26) du blindage (23) est fermée, de sorte que la tête de mesure (12) constitue un résonateur $\lambda/4$.

3. Tête de mesure selon la revendication 1 ou 2, caractérisée en ce que l'extrémité ouverte (25), formant le plan de pose (27), est couverte par un couvercle (62) en matériau non conducteur électrique, le couvercle (62) étant pourvu d'un certain nombre de pistes conductives (64) s'étendant radialement, dont les extrémités extérieures se raccordent à un boîtier (30) formant le blindage (23) et dont les extrémités intérieures s'étendent les unes vers les autres dans la zone du centre du couvercle (62), sans se toucher.

4. Tête de mesure selon la revendication 2 ou 3, caractérisée en ce qu'elle comporte un premier dispositif d'accord (38) par lequel la distance électrique $h_1$ de l'extrémité libre (43) de la ligne hélicoïdale (20) à l'autre extrémité (26) du blindage coaxial fermé (23) est variable.

5. Tête de mesure selon la revendication 4, caractérisée en ce que le premier dispositif d'accord (38) est constitué d'un fond (39) pourvu d'un revêtement conducteur (40) et correspondant à la forme de la section droite du blindage (23), fond qui est déplaçable par vissage dans un boîtier (30) formant le blindage (23).

6. Tête de mesure selon une des revendications 1 à 5, caractérisée en ce qu'elle comporte un dispositif d'accord supplémentaire (50, 55) par lequel le champ électrique E, généré par la ligne hélicoïdale (20), est chargé à un endroit axial défini auquel le champ électrique E présente seulement un maximum à un mode d'oscillation prédéterminé.

7. Tête de mesure selon la revendication 6, caractérisée en ce qu'un deuxième dispositif d'accord (50) est prévu entre la ligne hélicoïdale (20) et le blindage (23), ce dispositif étant constitué par une palette (51) électriquement conductrice, dont une extrémité (52) est reliée à un boîtier (30) formant le blindage et dont l'autre extrémité est déplaçable radialement.

8. Tête de mesure selon la revendication 6, caractérisée en ce qu'un troisième dispositif d'accord (55) est placé à l'intérieur de la ligne hélicoïdale (20).

9. Tête de mesure selon la revendication 8, caractérisée en ce que le troisième dispositif d'accord (55) est constitué par une boucle ouverte (56) qui est reliée d'un côté à un boîtier (30) formant le blindage (23) et qui est située dans un plan perpendiculaire à l'axe de la ligne hélicoïdale (20).

10. Tête de mesure selon une des revendications 1 à 9, caractérisée en ce qu'un quatrième dispositif d'accord (60) est prévu dans la liaison (28) entre la ligne hélicoïdale (20) et le blindage (23).

11. Tête de mesure selon la revendication 10, caractérisée en ce que le quatrième dispositif d'accord (60) est formé par un condensateur réglable.

12. Tête de mesure selon une des revendications 1 à 11, caractérisée en ce que la ligne hélicoïdale (20) est reliée à un émetteur haute fréquence (34) à amplitude réglable.

Fig. 1

Fig. 2

Fig. 3

Fig. 4

Fig. 5